# EUROPEAN PATENT APPLICATION

(11) **EP 2 587 506 A2**
(43) Date of publication of application: **01.05.2013**
(21) Application number: 12162173.4
(22) Date of filing: 29.03.2012
(51) Int. Cl.: H01G 9/20

(54) **Photoelectric module**

(30) Priority: 26.10.2011 US 201161551677 P; 28.03.2012 US 201213432469
(71) Applicant: Samsung SDI Co., Ltd., Yongin-si, Gyeonggi-do (KR)
(72) Inventor: Kim, Hyun-Chul, Gyeonggi-do (KR); Lee, Ji-Won, Gyeonggi-do (KR)
(74) Representative: Walaski, Jan Filip

(57) **Abstract**

A photoelectric module comprises first and second substrates, a sealing member disposed between the first and second substrates defining a plurality of photoelectric cells S, wherein the sealing member includes a cell divider and a plurality of island type connecting members connecting neighbouring photoelectric cells, the plurality of island type connecting members being arranged along the cell divider, further comprising first and second electrode layers arranged on the respective first and second substrates and a plurality of discrete finger electrodes extending from the cell divider into the photoelectric cells S on at least one of the first and second electrode layers, wherein the finger electrodes on one of the electrode layers are electrically connected to each other only via the electrode layer on which the finger electrodes are disposed.

## Description

The present invention relates to a photoelectric module.

Photoelectric devices convert light energy into electric energy and have been studied as an energy source for replacing fossil fuels, and solar cells using sunlight have come into the spotlight.

Various types of solar cells having various driving principles have been investigated. Silicon or crystalline solar cells having a wafer shape and including a p-n semiconductor junction are widespread, but the manufacturing costs thereof are high due to the characteristics of processes for forming and handling semiconductor materials having a high degree of purity.

Unlike silicon solar cells, dye-sensitized solar cells mainly include a photosensitive dye for generating excited electrons in response to visible light, a semiconductor material for receiving the excited electrons, and an electrolyte for reacting with the excited electrons in an external circuit. Dye-sensitized solar cells have high photoelectric conversion efficiency compared to silicon solar cells, and thus are expected to be the next generation of solar cells.

A series connection structure of such dye-sensitized solar cells includes a Z type, a W type, a monolith type, or an in-plane type. In the Z type, a conducting structure for connecting adjacent cells is required, and thus the light receiving area may be reduced and a resistance may increase.

According to the invention, there is provided a photoelectric module comprising first and second substrates and a sealing member disposed between the first and second substrates defining a plurality of photoelectric cells S, wherein the sealing member includes a cell divider, and a plurality of island type connecting members connecting neighbouring photoelectric cells, the plurality of island type connecting members being arranged along the cell divider, further comprising first and second electrode layers arranged on the respective first and second substrates and a plurality of discrete finger electrodes extending from the cell divider into the photoelectric cells S on at least one of the first and second electrode layers, wherein the finger electrodes on one of the electrode layers are electrically connected to each other only via the electrode layer on which the finger electrodes are disposed.

In other words the finger electrodes are not connected to one another by a common base electrode that joins all of the fingers together, as in a conventional comb electrode arrangement.

The cell divider may extend in a first direction, the cell divider including holes for receiving the island type connecting members, wherein the finger electrodes extend in a second direction perpendicular to the first direction.

The island type connecting members may be arranged to electrically connect the first electrode layer of a first one of the neighbouring photoelectric cells to the second electrode layer of a second one of the neighbouring photoelectric cells.

The first electrode layer may comprise a photoelectrode and the second electrode layer may comprise a counter electrode, and the photoelectric module may further comprise a semiconductor layer formed on the photoelectrode having a photosensitive dye adsorbed thereto and an electrolyte disposed between the semiconductor layer and the counter electrode.

The photoelectric module may comprise first finger electrodes on the first electrode layer and second finger electrodes on the second electrode layer.

The first finger electrodes may be connected to corresponding ones of the second finger electrodes by the island type connecting members. The finger electrodes may be in contact with the island type connecting members or may be spaced apart from the island type connecting members.

The ends of the finger electrodes nearest the island type connecting members may be from 14 to 25 mm from the island type connecting members.

The finger electrodes may be parallel to one another. Each of the finger electrodes may correspond to a respective one of the island type connecting members.

The photoelectric module may further comprise finger electrodes between the island type connecting members.

Alternatively, none of the finger electrodes may be aligned with the island type connecting members.

The finger electrodes may comprise a metal having a higher conductivity than that of the electrode on which they are disposed. The photoelectric module may further comprise a protection layer on the finger electrodes.

Embodiments of the invention will now be described, by way of example, with reference to the accompanying drawings, in which:
FIG. 1 is an upper plane view of a photoelectric module according to an embodiment of the present invention.
FIG. 2 is an exploded perspective view schematically illustrating a photoelectric module according to an embodiment of the present invention.
FIG. 3 is a cross-sectional view taken along a line III-III of FIG. 1.
FIG. 4 is a cross-sectional view taken along a line IV-IV of FIG. 1.
FIG. 5 is a cross-sectional view taken along a line V-V of FIG. 1.
FIG. 6 is a perspective view of a partial structure of a photoelectric module, wherein neighbouring photoelectric cells are electrically connected to each other via an island type connecting member, according to an embodiment of the present invention.
FIG. 7 is a perspective view of a partial structure of a photoelectric module, wherein neighbouring photoelectric cells are electrically connected to each other via an island type connecting member, according to another embodiment of the present invention.
FIG. 8 is a perspective view of a partial structure of a photoelectric module, wherein neighbouring photoelectric cells are electrically connected to each other via an island type connecting member, according to another embodiment of the present invention.
FIG. 9 is a perspective view of a partial structure of a photoelectric module, wherein neighbouring photoelectric cells are electrically connected to each other via an island type connecting member, according to another embodiment of the present invention.

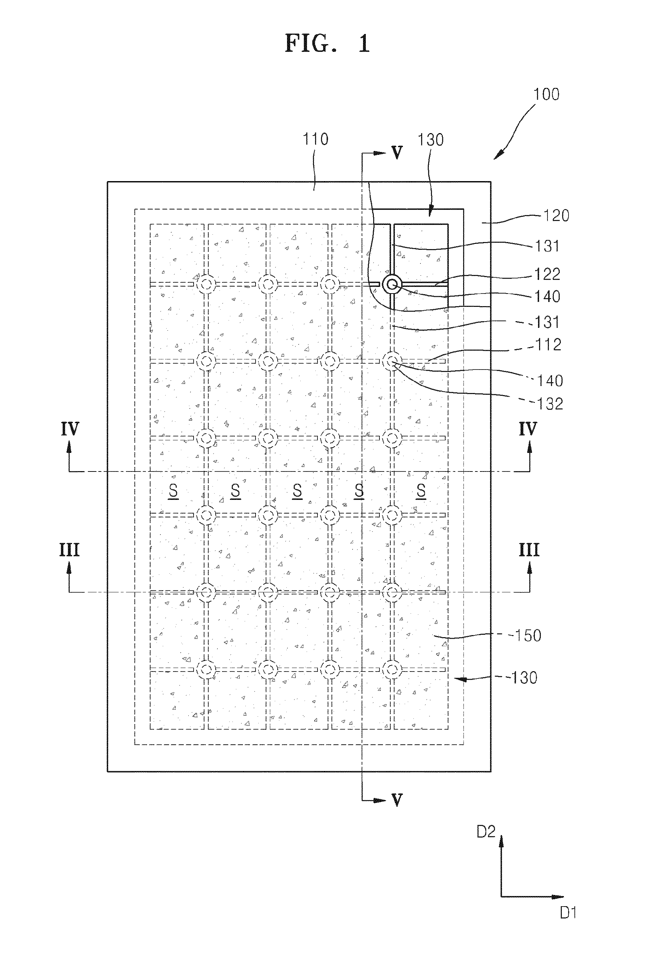

Referring to FIG. 1, a photoelectric module 100 includes a plurality of photoelectric cells S. The plurality of photoelectric cells S may be arranged in parallel with each other in one direction, and divided by a sealing member 130. The photoelectric cells S may be modularized by being physically supported by the sealing member 130 between a first substrate 110 and a second substrate 120, which face each other.

An electrolyte 150 is filled inside the photoelectric cell S. The electrolyte 150 is sealed by the sealing member 130 that surround the entire photoelectric cells S while being arranged between the neighbouring photoelectric cells S. For example, the sealing member 130 may be disposed around the electrolyte 150 to surround the electrolyte 150 so as to prevent the electrolyte 150 from leaking.

The sealing member 130 includes at least one space defining the photoelectric cell S. The plurality of photoelectric cells S are spatially divided by a cell divider 131 disposed between the neighbouring photoelectric cells S, and are electrically connected to each other by an island type connecting member 140 formed along the cell divider 131. The island type connecting members are also referred to as discrete connecting members.

The sealing member 130 includes the cell divider 131 dividing the neighbouring photoelectric cells S and a hole 132 formed along the cell divider 131 and accommodating the island type connecting member 140. Since the island type connecting member 140 is disposed in the hole 132 formed on the sealing member 130, the island type connecting member 140 may be protected from the electrolyte 150 as the island type connecting member 140 is surrounded by a sealing material. The island type connecting member 140 accommodated in the hole 132 may point-connect the neighbouring photoelectric cells S. In other words, the plurality of photoelectric cells S may be connected in series via at least one connection point. A plurality of the island type connecting member 140 may electrically connect the neighbouring photoelectric cells S by being spaced apart from each other along the cell divider 131.

Although the island type connecting member 140 is protected from the electrolyte 150 by being surrounded by the sealing material, the cell divider 131 is sufficient enough as long as it spatially separates the neighbouring photoelectric cells S, and thus a thickness of the cell divider 131 may be thin. Accordingly, generation of a dead area constituting a non-photoelectric conversion area formed between the photoelectric cells S forming the photoelectric module 100 may be reduced.

In order to reduce the dead area while improving efficiency of photoelectric conversion, first and second finger electrodes 112 and 122 may be disposed approximately perpendicular to an arranged direction of the plurality of island type connecting member 140 (or a length direction of the photoelectric cell S). The first and second finger electrodes 112 and 122 may be arranged parallel to each other to form a stripe pattern.

By using the first and second finger electrodes 112 and 122, the number of island type connecting members 140 may be remarkably reduced. For example, when the length of a photoelectric cell is about 150 mm in a photoelectric module that does not include a finger electrode, island type connecting members for point-connection may be arranged at intervals ranging from about 4 mm to about 9 mm.

On the other hand, when the length of the photoelectric cell S of the photoelectric module 100 including the first and second finger electrodes 112 and 122 is about 150 mm, the island type connecting members 140 for point-connection may be arranged at intervals ranging from about 9 mm to about 25 mm, and efficiency may also remarkably increase.

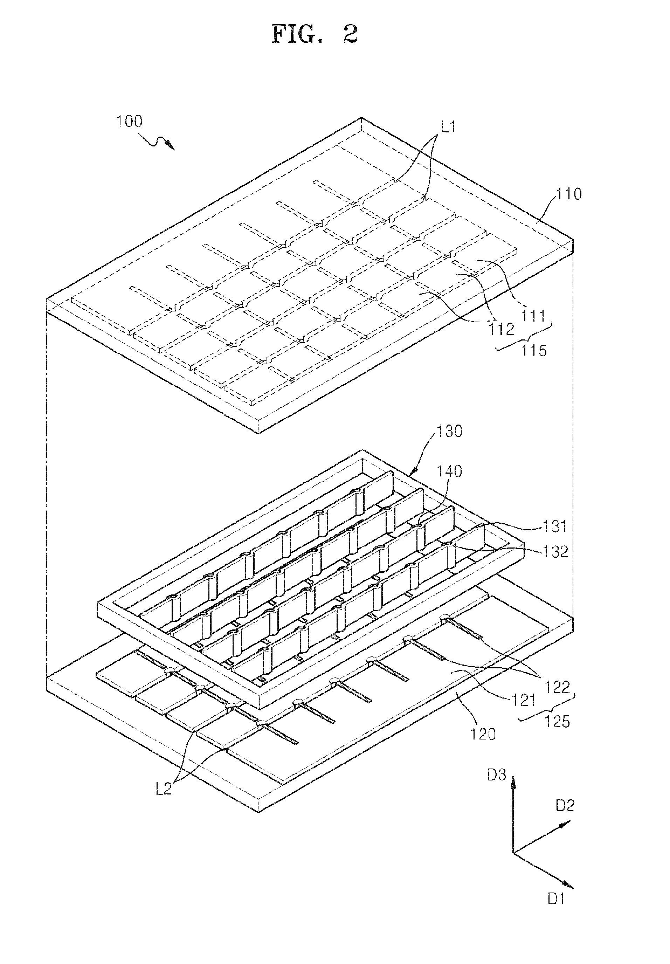

FIG. 2 is an exploded perspective view schematically illustrating a photoelectric module according to an embodiment of the present invention. For convenience of description, FIG. 2 only shows a photoelectrode 111 and the first finger electrode 112 on the first substrate 110, and a counter electrode 121 and the second finger electrode 122 on the second substrate 120. The photoelectrode 111, the first finger electrode 112, and a semiconductor layer (not shown) may form a first electrode unit 115 of the photoelectric cell S, and the counter electrode 121, the second finger electrode 122, and a catalyst layer (not shown) may form a second electrode unit 135 of the photoelectric cell S.

Referring to FIG. 2, the sealing member 130 is disposed between the first and second substrates 110 and 120 facing each other to prevent the electrolyte 150 from leaking, and defines the plurality of photoelectric cells S via the cell divider 131. The cell divider 131 includes the plurality of holes 132 to accommodate the island type connecting members 140, and as described above with reference to FIG. 1, the island type connecting members 140 formed in the holes 132 may be spaced apart from each other along the cell divider 131.

A scribe line L1 enabling an upper portion of the cell divider 131 to be combined to the first substrate 110 may be formed on the first electrode unit 115 formed on the first substrate 110. Also, a scribe line L2 enabling a lower portion of the cell divider 131 to be combined to the second substrate 120 may be formed on the second electrode unit 135 formed on the second substrate 120. The upper and lower portions of the cell divider 131 may be combined to the first and second substrate 110 and 120 via the scribe lines L1 and L2 by using an adhesive material such as a hot melt adhesive while directly contacting the first and second substrates 110 and 120.

The first finger electrode 112 is formed on the photoelectrode 111 and extends in a direction approximately perpendicular to the cell divider 131. The plurality of first finger electrodes 112 may be parallel to each other to form a stripe pattern. The second finger electrode 122 is formed on the counter electrode 121 and extends in a direction approximately perpendicular to the cell divider 131. The plurality of second finger electrodes 122 may be parallel to each other to form a stripe pattern.

A conventional finger electrode arrangement is a comb type including first finger units parallel to each other and a second finger unit perpendicular to the first finger units and connected to an end of each first finger unit to connect the first finger units together. However, a finger electrode according to an embodiment of the present invention only includes the first finger units, also referred to as discrete finger electrodes, parallel to each other. The discrete electrodes on one substrate are not physically or electrically connected to each other at the same layer, for example by a common base electrode running the length of the finger arrangement, but are only electrically connected to one another through the electrode layer on which they are disposed.

In the conventional comb type finger electrode arrangement, the second finger unit of one photoelectric cell should be covered by a sealing member so as to prevent the second finger unit from being exposed to a neighbouring photoelectric cell. Accordingly, when the comb type finger electrode arrangement is used, a cell divider disposed between photoelectric cells covers the second finger unit, and thus a thickness of the cell divider is more than a thickness of the second finger unit. However, the first and second finger electrodes 112 and 122 according to an embodiment of the present invention only include the first finger units parallel to each other, and thus a thickness of the cell divider 131 is not increased. Accordingly, a dead area constituting a non-photoelectric conversion area between the neighbouring photoelectric cells S is reduced.

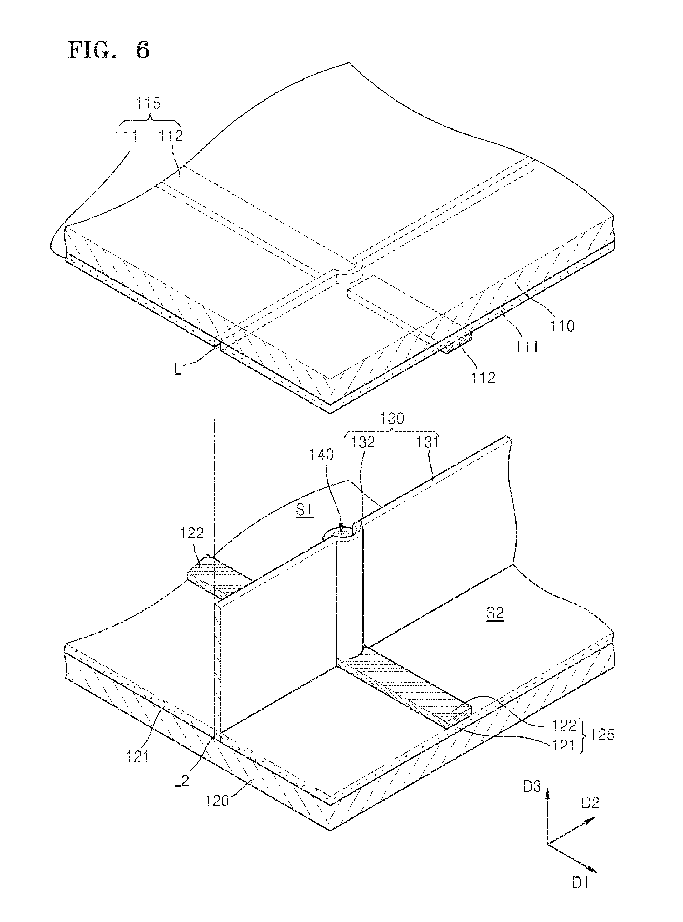

In FIG. 2, 6 island type connecting members 140 are used to electrically connect the neighbouring photoelectric cells S, but the number of island type connecting members 140 is not limited thereto.

Also, in FIG. 2, the first and second finger electrodes 112 and 122 correspond to the island type connecting member 140 in a one-to-one manner, but the present invention is not limited thereto. For example, the first and second finger electrodes 112 and 122 may be further disposed, or may not be disposed, between the neighbouring island type connecting members 140. In other words, the number of the first and second finger electrodes 112 and 122 may be more than or less than the number of island type connecting members 140 included in one cell divider 131.

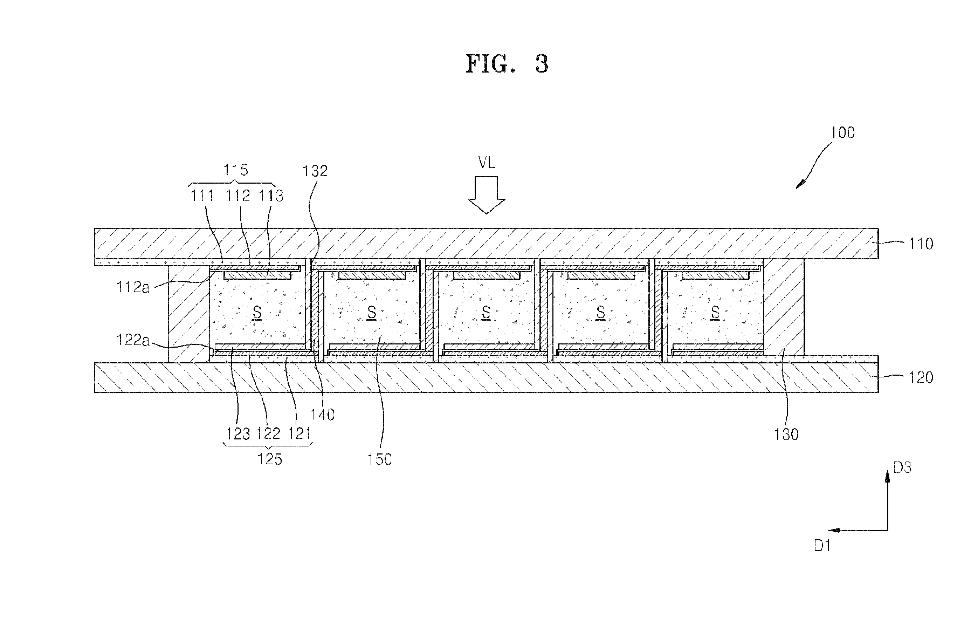

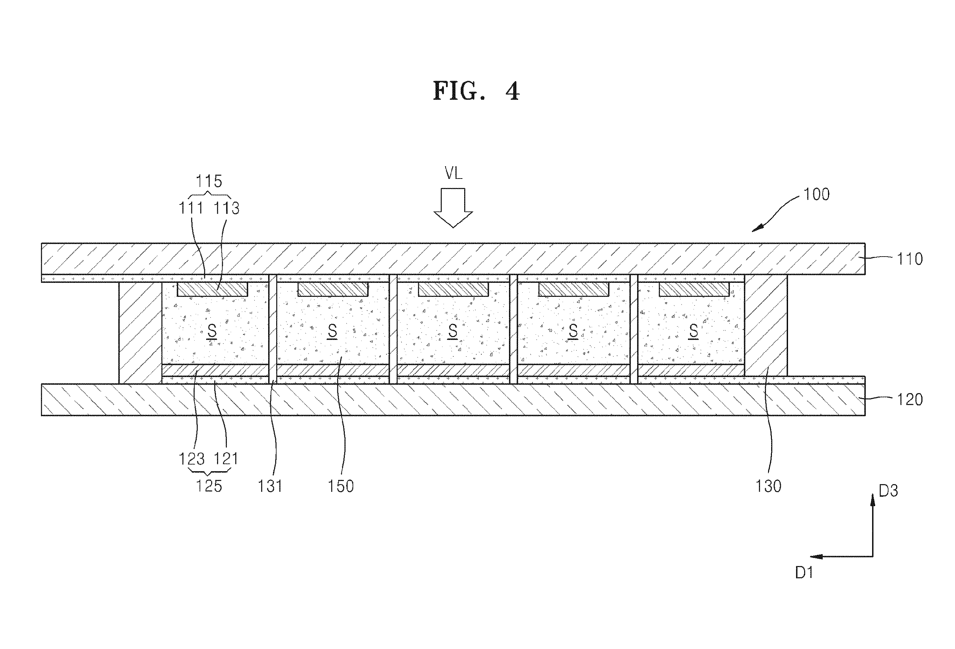

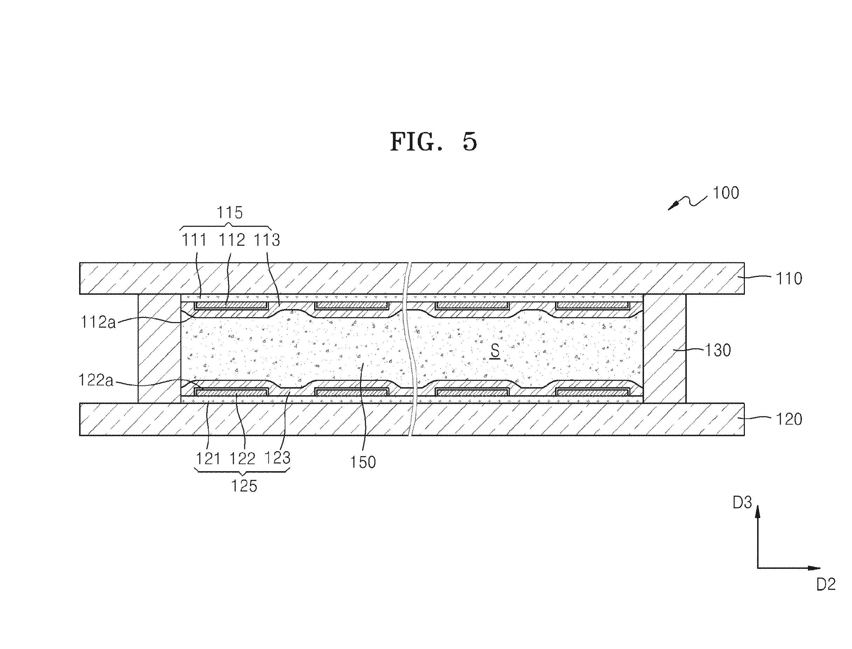

Since the photoelectric cells S are point-connected via the island type connecting members 140 in the photoelectric module 100 according to an embodiment of the present invention, a region with the island type connecting member 140 of FIG. 3 and a region without the island type connecting member 140 of FIG. 4 co-exist. Also, since the photoelectric module 100 according to an embodiment of the present invention includes the first and second finger electrodes 112 and 122 approximately perpendicular to an arranged direction of the photoelectric cells S, the photoelectric cells S may include the first and second finger electrodes 112 and 122 as shown in FIG. 5.

Referring to FIGS. 3 through 5, the photoelectric module 100 includes the first and second substrates 110 and 120 facing each other, and the plurality of photoelectric cells S defined by the sealing member 130 are formed between the first and second substrates 110 and 120. The island type connecting member 140 is disposed between the neighbouring photoelectric cells S to connect the neighbouring photoelectric cells S. The first and second electrode units 115 and 125 for performing photoelectric conversion are formed on the first and second substrates 110 and 120, and the electrolyte 150 is disposed between the first and second electrode units 115 and 125.

The first and second substrates 110 and 120 may have an approximately rectangular shape. The first substrate 110 may be a light-receiving substrate and formed of a transparent material having high light transmittance. The first substrate 110 may be a glass substrate. Alternatively, the first substrate 110 may be formed of bendable plastic, such as polyethyleneterephthalate (PET), polycarbonate (PC), polyimide (PI), polyethylenenaphthalate (PEN), or polyethersulfone (PES).

The second substrate 120 is a counter substrate and is disposed to face the first substrate 110 constituting a light-receiving substrate. Although a counter substrate is not specifically required to be transparent, it may be formed of a transparent material to receive light VL from both sides so as to increase efficiency of photoelectric conversion. Thus, the second substrate 120 may be formed of the same material as the first substrate 110. For example, if the photoelectric module 100 is used for a building integrated photovoltaic (BIPV) installed in a structure such as a window frame, the first and second substrates 110 and 120 may both be formed of a transparent material so as not to block the light VL transmitted through the window.

The first and second substrates 110 and 120 may be adhered to each other while having a space therebetween for the sealing member 130 to be disposed. The first and second electrode units 115 and 135 are respectively disposed on the first and second substrates 110 and 120. The first electrode unit 115 includes the photoelectrode 111, the first finger electrode 112, and a semiconductor layer 113 adsorbing photosensitive dye molecules, and the second electrode unit 135 includes the counter electrode 121, the second finger electrode 122, and a catalyst layer 123. The photoelectrode 111 may operate as a negative electrode of the photoelectric module 100 and provide a current path by collecting electrons generated through conversion. The light VL incident through the photoelectrode 111 operates as an excitation source of dye molecules adsorbed to the semiconductor layer 113. The photoelectrode 111 may be formed of a transparent conducting oxide (TCO) having electric conductivity and transparency, such as indium tin oxide (ITO), fluorine doped SnO₂ (FTO), or ATO.

The photoelectrode 111 is formed to increase the efficiency of forming electrons. The photoelectrode 111 has high transparency so sunlight easily reaches the dye molecules, but has high electrical resistance, and thus efficiency may be decreased. Accordingly, the first finger electrode 112 may be disposed on the photoelectrode 111.

The first finger electrode 112 is formed on the photoelectrode 111, and may reduce electrical resistance of the photoelectrode 111. The first finger electrode 112 may be formed of a metal having excellent electric conductivity, such as silver (Ag) or aluminum (Al), and the plurality of first finger electrodes 112 may be disposed parallel to each other to form a stripe pattern. Since the electrical resistance of the first finger electrode 112 is lower than that of the photoelectrode 111, a current flows smoothly. The first finger electrode 112 may be covered with a protection layer 112a to protect the first finger electrode 112 from the electrolyte 150.

The semiconductor layer 113 may be formed of a nano-sized semiconductor oxide layer. The oxide layer may include at least one selected from the metal group consisting of cadmium (Cd), zinc (Zn), indium (In), lead (Pb), molybdenum (Mo), tungsten (W), antimony (Sb), titanium (Ti), silver (Ag), manganese (Mn), tin (Sn), zirconium (Zr), strontium (Sr), gallium (Ga), silicon (Si) and chromium (Cr).

The nano-sized semiconductor oxide layer may have a structure in which a plurality of nanometer sized wide band gap semiconductor particles are stacked on each other at suitable intervals, and a photosensitive dye, for example, dye molecules formed of ruthenium (Ru) complex compound, may be chemically adsorbed onto surfaces of the nanometer sized wide band gap semiconductor particles.

The dye molecules may be molecules showing adsorption in a visible ray band and quickly transferring electrons from a light excitation state to the semiconductor layer 113. For example, the dye molecules may include Ru complex compound. Also, the dye molecules may be thiophene, phthalocyanine, porphyrin, indoline, or an organic substance containing quinoline, and derivatives thereof.

The dye molecules adsorbed to the semiconductor layer 113 absorb the light VL incident through the first substrate 110, and electrons of the dye molecules are excited from a ground state to an excited state. The excited electrons are transferred to a conduction band of the semiconductor layer 113 via bonds between the dye molecules and the semiconductor layer 113, reach the photoelectrode 111 through the semiconductor layer 113 after transference, and form a driving current for driving an external circuit (not shown) by being extracted outside via the photoelectrode 111.

The counter electrode 121 may operate as a positive electrode of the photoelectric module 100. The counter electrode 121 may participate in reduction of the electrolyte 150. For example, the electrons of the dye molecules adsorbed to the semiconductor layer 113 are excited by absorbing the light VL, and the excited electrons are extracted outside through the photoelectrode 111. The photosensitive dye that lost electrons may be reduced again by collecting electrons provided via oxidation of the electrolyte 150. The oxidized electrolyte 150 is reduced by the electrons that reach the counter electrode 121 through the external circuit, and thus an operation of photoelectric conversion is completed.

Like the photoelectrode 111, the counter electrode 121 may be formed of a TCO having electric conductivity and transparency, such as ITO, FTO, or ATO. The second finger electrode 122 may be formed on the counter electrode 121 so as to compensate high electrical resistance of the counter electrode 121. The second finger electrode 122 may include a metal having excellent electric conductivity, such as Ag or Al, and the plurality of second finger electrodes 122 may be parallel to each other to form a stripe pattern. Since electrical resistance of the second finger electrode 122 is lower than that of the counter electrode 121, a current may flow more easily. The second finger electrode 122 may be covered by a protection layer 122a to be protected from the electrolyte 150.

The catalyst layer 123 may be formed on the counter electrode 121 and the protection layer 122a. The catalyst layer 123 may include a platinum (Pt) or carbon (C) thin film. The catalyst layer 123 operates as a reduction catalyst for receiving electrons from the external circuit. Also, by depositing a Pt thin film on the catalyst layer 123, the light VL incident through the photoelectrode 111 may be reflected, thereby increasing conversion efficiency of sun energy.

The electrolyte 150 may be disposed between the first and second electrode units 115 and 135, for example, between the semiconductor layer 113 and the catalyst layer 123. The electrolyte 150 may include a iodine-based oxidation-reduction liquid electrolyte (I3-/I-). The electrolyte 150 reduces the oxidized dye molecules. In the current embodiment, a liquid electrolyte is used as the electrolyte 150, but the electrolyte 150 may be a solid type or gel type.

FIG. 6 is a perspective view of a partial structure of a photoelectric module, wherein neighboring photoelectric cells are electrically connected to each other via an island type connecting member, according to an embodiment of the present invention. For convenience of description, FIG. 6 only illustrates the photoelectrode 111 and the first finger electrode 112 of the first electrode unit 115, and the counter electrode 121 and the second finger electrode 122 of the second electrode unit 135, and does not illustrate the semiconductor layer, the catalyst layer, and the protection layers of the first and second finger electrodes 112 and 122.

Referring to FIG. 6, photoelectric cells S1 and S2 are disposed across the cell divider 131 of the sealing member 130 disposed between the first and second substrates 110 and 120 facing each other. The photoelectrode 111 is formed on the first substrate 110, the counter electrode 121 is formed on the second substrate 120, and the scribe lines L1 and L2 are disposed on the photoelectrode 111 and the counter electrode 121 so that the cell divider 131 and the first and second substrates 110 and 120 are combined to each other. The first and second substrates 110 and 120 may be spaced apart from each other and supported by the cell divider 131.

The neighbouring photoelectric cells S1 and S2 are connected in series by the island type connecting member 140 included in the hole 132 of the sealing member 130. For example, the island type connecting member 140 may contact the first electrode unit 115 of the photoelectric cell S1 disposed at left and at the same time, may contact the second electrode unit 135 of the photoelectric cell S2 at right, thereby connecting the photoelectric cells S1 and S2 in series. Here, an upper portion of the island type connecting member 140 may contact the first finger electrode 112 of the photoelectric cell S1 at left and a lower portion of the island type connecting member 140 may contact the second finger electrode 122 of the photoelectric cell S2 at right.

The first and second finger electrodes 112 and 122 extend in a direction approximately perpendicular to the cell divider 131 to be electrically connected to the island type connecting member 140 via physical contact. Since the first and second finger electrodes 112 and 122 according to an embodiment of the present invention extend in the direction approximately perpendicular to the cell divider 131 and are parallel to each other, the cell divider 131 according to an embodiment of the present invention may be sufficient enough to only spatially divide the neighboring photoelectric cells S1 and S2. Accordingly, the cell divider 131 may be thin, thereby a dead area is reduced as described above with reference to FIG. 2.

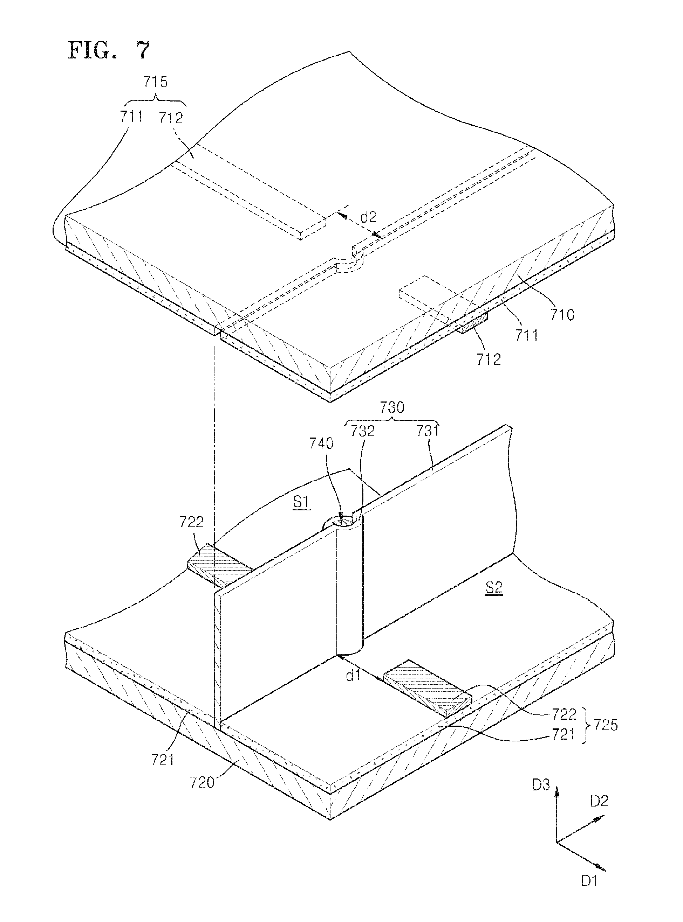

FIG. 7 is a perspective view of a partial structure of a photoelectric module, wherein neighbouring photoelectric cells are electrically connected to each other via an island type connecting member, according to another embodiment of the present invention. For convenience of description, FIG. 7 only illustrates only an photoelectrode 711 and a first finger electrode 712 of a first electrode unit 715, and only a counter electrode 721 and a second finger electrode 722 of a second electrode unit 735. A semiconductor layer, a catalyst layer and protection layers of the first and second finger electrodes 712 and 722 are not shown. Referring to FIG. 7, the photoelectric cells S1 and S2 are disposed across a cell divider 731 of a sealing member 730 disposed between first and second substrates 710 and 720 facing each other. The photoelectrode 711 is formed on the first substrate 710, the counter electrode 721 is formed on the second substrate 720 and the first and second substrates 710 and 720 may be spaced apart from each other while being supported by the cell divider 731.

In the photoelectric module according to the current embodiment, an island type connecting member 740 is electrically connected to the first electrode unit 715 of the photoelectric cell S1 at left, and at the same time, is electrically connected to the second electrode unit 735 of the photoelectric cell S2 at right, thereby connecting the photoelectric cells S1 and S2 in series.

However, in the current embodiment, the first and second finger electrodes 712 and 722 do not directly contact the island type connecting member 740. An upper portion of the island type connecting member 740 is electrically connected to the photoelectrode 711 via direct contact, and a lower portion of the island type connecting member 740 is electrically connected to the counter electrode 721 via direct contact, thereby electrically connecting the neighbouring photoelectric cells S1 and S2.

The first and second finger electrodes 712 and 722 extend in a direction approximately perpendicular to the cell divider 731, and may be spaced apart from each other to form a stripe pattern. Here, the first and second finger electrodes 712 and 722 may be spaced apart from the island type connecting member 740, which is accommodated in the hole 732 of the cell divider 731, respectively by predetermined distances d2 and d1. For example, the predetermined distances d1 and d2 may be in the range from about 14 mm to about 25 mm.

When the predetermined distances d1 and d2 are less than 14 mm or more than 25 mm, current density deteriorates, and thus photoelectric conversion efficiency may deteriorate.

By disposing the first and second finger electrodes 712 and 722 apart from the cell divider 731 by the predetermined distances d1 and d2, manufacturing costs of the photoelectric module may be reduced while not affecting functions of the first and second finger electrodes 712 and 722. Also, by forming the first and second finger electrodes 712 and 722 to be short, an area blocking light by the first and second finger electrodes 712 and 722 may be reduced, thereby increasing photoelectric conversion efficiency.

Since the first and second finger electrodes 712 and 722 according to an embodiment of the present invention also extend in the direction approximately perpendicular to the cell divider 731 and are parallel to each other, the cell divider 731 according to an embodiment of the present invention is sufficient enough to spatially divide the neighbouring photoelectric cells S1 and S2. Accordingly, a thickness of the cell divider 731 may be thin, and thus a dead area may be reduced.

Since the photoelectric modules according to the embodiments of the present invention uses the island type connecting member, a dead area between the neighbouring photoelectric cells may be reduced. In other words, the thickness of the cell divider may be thin except for the hole for accommodating the island type connecting member, the area of the dead area may be reduced.

Also, by forming the plurality of finger electrodes parallel to each other and approximately perpendicular to the cell divider, instead of a comb type finger electrode arrangement, the thickness of the cell divider is not unnecessarily increased, and thus the dead area may be reduced. Moreover, by using the first and second finger electrodes, the number of island type connecting members may be reduced.

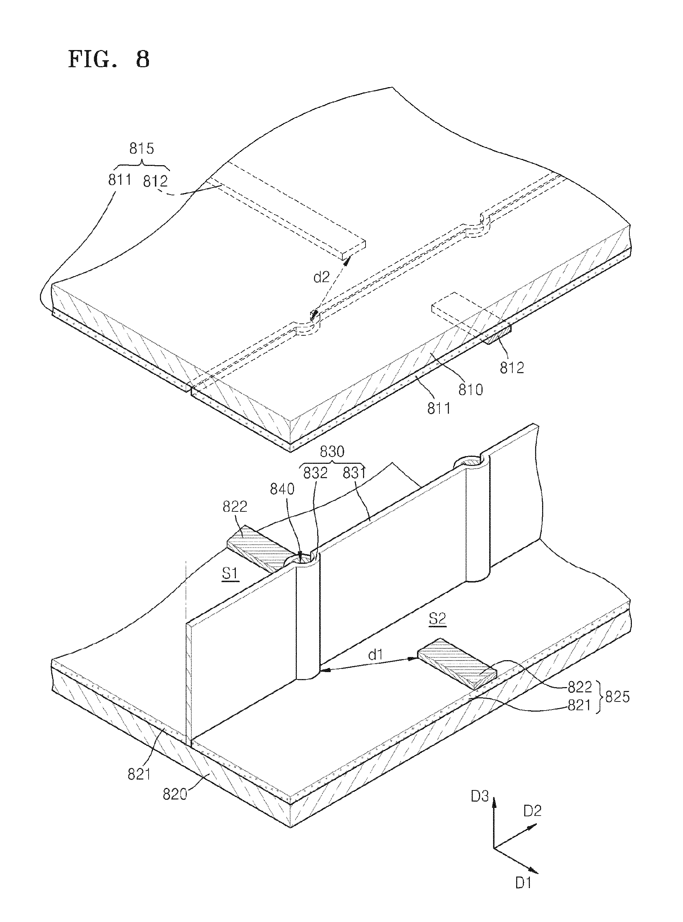

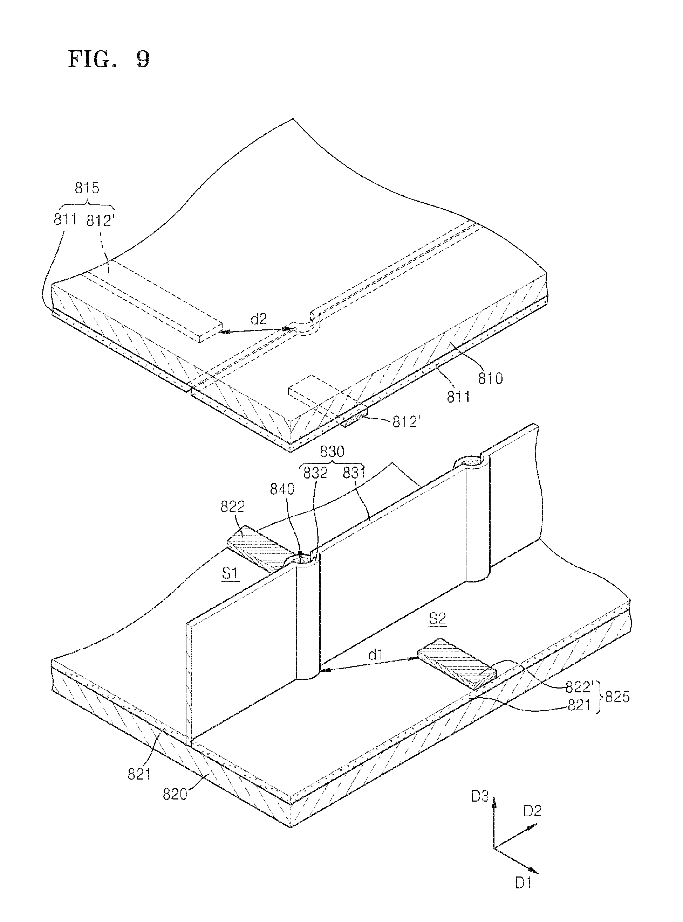

Figures 8 and 9 represent further exemplary embodiments having the same general structure as that shown in Figure 7. However, in Figures 8 and 9, the first and second finger electrodes 812, 812', 822, 822' are offset from, in other words, not aligned with the island type connecting members 840.

In more detail, in Figure 8, the first and second finger electrodes 812, 822, are substantially perpendicular to the cell divider 831 and lie between two island type connecting members 840. The first finger electrodes 812 on the first substrate 810 are aligned with the second finger electrodes 822 on the second substrate 820 in the vertical direction D3.

In contrast, in Figure 9, the first and second finger electrodes 812', 822' are not aligned with each other in the vertical direction D3. The first and second finger electrodes on the first and second substrates can therefore be seen to alternate in position between the first and second substrates.

The skilled person would understand that numerous electrode arrangements are possible and that the electrode arrangements are not strictly limited to those shown, but include different regular and irregular electrode patterns and offset distances as well as combinations of the different arrangements from different embodiments. For example, the arrangement shown in Figure 6 or Figure 7 can be combined with the arrangements shown in either of Figures 8 and 9.

## Claims

1. A photoelectric module (100) comprising:
first and second substrates (110, 120);
a sealing member (130) disposed between the first and second substrates defining a plurality of photoelectric cells S, wherein the sealing member includes a cell divider; and
a plurality of island type connecting members (140) connecting neighbouring photoelectric cells, the plurality of island type connecting members being arranged along the cell divider, further comprising:
first and second electrode layers (111, 121) arranged on the respective first and second substrates; and
a plurality of discrete finger electrodes extending from the cell divider into the photoelectric cells S on at least one of the first and second electrode layers, wherein the finger electrodes on one of the electrode layers are electrically connected to each other only via the electrode layer on which the finger electrodes are disposed.

2. The photoelectric module of claim 1, wherein the cell divider (131) extends in a first direction, the cell divider including holes (132) for receiving the island type connecting members, wherein the finger electrodes (112, 122) extend in a second direction perpendicular to the first direction.

3. The photoelectric module of claim 1 or 2, wherein the island type connecting members (140) are arranged to electrically connect the first electrode layer (111) of a first one of the neighbouring photoelectric cells to the second electrode layer (121) of a second one of the neighbouring photoelectric cells.

4. The photoelectric module of claim 3, wherein the first electrode layer comprises a photoelectrode (111) and the second electrode layer comprises a counter electrode (121), further comprising:
a semiconductor layer (113) formed on the photoelectrode having a photosensitive dye adsorbed thereto; and
an electrolyte disposed between the semiconductor layer and the counter electrode (121).

5. The photoelectric module of claim 3 or 4, comprising first finger electrodes on the first electrode layer and second finger electrodes on the second electrode layer.

6. The photoelectric module of claim 5, wherein the first finger electrodes are connected to corresponding ones of the second finger electrodes by the island type connecting members.

7. The photoelectric module of any one of the preceding claims, wherein the finger electrodes are in contact with the island type connecting members.

8. The photoelectric module of any one of claims 1 to 5, wherein the finger electrodes are spaced apart from the island type connecting members.

9. The photoelectric module of claim 8, wherein the ends of the finger electrodes nearest the island type connecting members (140) are from 14 to 25 mm from the island type connecting members.

10. The photoelectric module of any one of the preceding claims, wherein the finger electrodes are parallel to one another.

11. The photoelectric module of any one of the preceding claims, wherein each of the finger electrodes corresponds to a respective one of the island type connecting members.

12. The photoelectric module of any one of claims 1 to 10, further comprising finger electrodes between the island type connecting members.

13. The photoelectric module of any one of claims 1 to 5, wherein none of the finger electrodes are aligned with the island type connecting members.

14. The photoelectric module of any one of the preceding claims, wherein the finger electrodes comprise a metal having a higher conductivity than that of the electrode on which they are disposed.

15. The photoelectric module of any one of the preceding claims, further comprising a protection layer (112a, 122a) on the finger electrodes.
